# DEMANDE DE BREVET EUROPEEN

(11) **EP 4 738 628 A1**
(43) Date de publication de la demande: **06.05.2026**
(21) Numéro de dépôt: 25210216.5
(22) Date de dépôt: 21.10.2025
(51) Int. Cl.: H02B 1/056, H01H 71/00, H05K 7/14, H02B 1/044

(54) **TABLEAU ELECTRIQUE POUR UN AERONEF**

(30) Priorité: 30.10.2024 FR 2411874
(71) Demandeur: AIRBUS OPERATIONS (S.A.S.), 31060 Toulouse (FR)
(72) Inventeur: DE KERGOMMEAUX, Matthieu, 31060 Toulouse (FR); BOISNIER, Benjamin, 31060 Toulouse (FR); CAZALBON, Jean-André, 31060 Toulouse (FR)
(74) Mandataire: BCF Global

(57) **Abrégé**

L'invention concerne un tableau électrique pour un aéronef, comprenant une première plaque (3), dite plaque avant, une deuxième plaque (4), dite platine arrière, une troisième plaque (7) comprenant un circuit imprimé, dite plaque PCB, la plaque PCB (7) comprenant une unité de traitement d'informations, une quatrième plaque (5) pour l'alimentation électrique d'au moins un disjoncteur (2), dite plaque d'alimentation électrique, la plaque PCB (7) et la plaque d'alimentation électrique (5) étant disposées entre la plaque avant (3) et la platine arrière (4), chacune desdites plaques (3, 4, 5, 7) étant munie d'au moins un orifice de passage dudit disjoncteur (2).

## Description

### Domaine technique

La présente invention se rapporte à un tableau électrique pour un aéronef.

### Technique antérieure

Un aéronef comporte une multitude d'équipements électriques, connectés entre eux par des circuits électriques complexes et munis d'interrupteurs de circuits, ou disjoncteurs, afin d'assurer la sécurité des équipements. De tels circuits électriques nécessitent un grand nombre de câblages, et s'avèrent à la fois encombrants et longs à préparer.

Le but de l'invention est de remédier au moins partiellement à ces inconvénients.

### Résumé

A cet effet, il est proposé un tableau électrique pour un aéronef, comprenant une première plaque, dite plaque avant, une deuxième plaque, dite platine arrière, une troisième plaque comprenant un circuit imprimé, dite plaque PCB, la plaque PCB comprenant une unité de traitement d'informations, une quatrième plaque d'alimentation électrique d'au moins un disjoncteur, dite plaque d'alimentation électrique, la plaque PCB et la plaque d'alimentation électrique étant disposées entre la plaque avant et la platine arrière, chacune des plaques étant munie d'au moins un orifice de passage d'un disjoncteur.

Le tableau électrique selon la présente invention assure un gain de place par sa forme plane, et s'avère facile à installer, non seulement grâce à sa succession de plaques, mais aussi par la plaque d'alimentation électrique qui réduit le nombre de câbles nécessaires.

Selon un autre aspect, lesdits au moins un orifice de passage d'un disjoncteur sont superposés de manière à permettre le passage du disjoncteur dans chacun des orifices prévus.

Selon un autre aspect, le tableau électrique comprend une plaque d'isolation électrique entre la plaque d'alimentation électrique et la plaque PCB.

Selon un autre aspect, la platine arrière comprend au moins un logement d'installation dudit disjoncteur.

Selon un autre aspect, la plaque PCB comprend une étiquette contenant de l'encre électrique, l'unité de traitement d'informations étant configurée pour commander des indications visuelles à l'encre électrique de l'étiquette.

Selon un autre aspect, le tableau électrique comprend un moyen de détermination de son propre positionnement relativement à un schéma électrique de l'aéronef, conformé pour communiquer avec l'unité de traitement d'informations.

Selon un autre aspect, le tableau électrique comprend un moyen de verrouillage du disjoncteur dans le tableau électrique.

L'invention a également pour objet un disjoncteur pour un tableau électrique tel que décrit précédemment, comprenant un moyen d'identification du disjoncteur.

Selon un autre aspect, le disjoncteur comprend un moyen de visualisation d'un état verrouillé du disjoncteur dans le tableau électrique et d'un état déverrouillé du disjoncteur.

L'invention a également pour objet une armoire électrique pour un aéronef, comprenant au moins un tableau électrique tel que décrit précédemment et/ou au moins un disjoncteur tel que décrit précédemment.

L'invention a également pour objet un aéronef, comprenant au moins un tableau électrique tel que décrit précédemment et/ou au moins un disjoncteur tel que décrit précédemment et/ou au moins une armoire électrique telle que décrite précédemment.

### Brève description des dessins

D'autres caractéristiques, détails et avantages apparaîtront à la lecture de la description détaillée ci-après, et à l'analyse des dessins annexés, sur lesquels :
**Fig. 1**

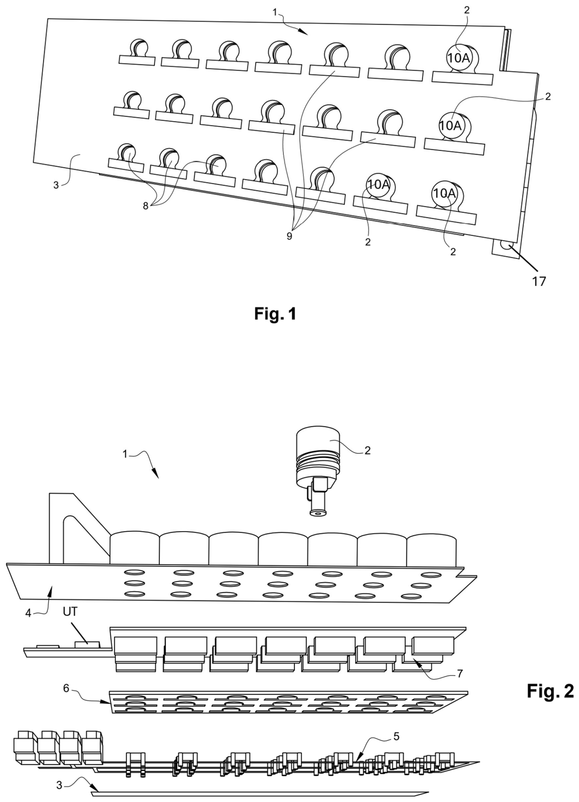

   [Fig. 1] est une vue schématique en perspective avant d'un tableau électrique selon la présente invention.
**Fig. 2**
   [Fig. 2] est une vue schématique éclatée du tableau électrique de la figure 1.
**Fig. 3**

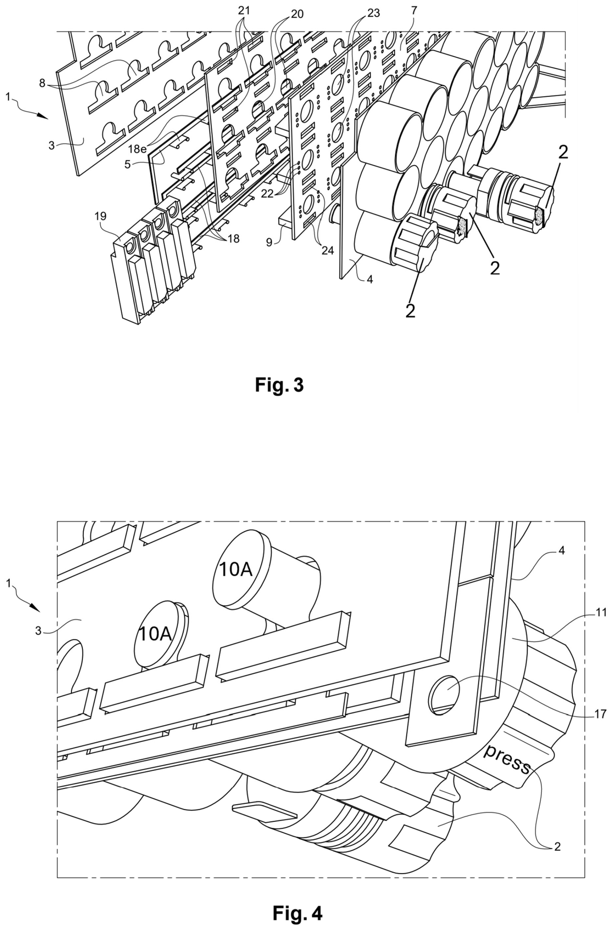

   [Fig. 3] est une vue schématique en perspective du tableau électrique de la figure 2.
**Fig. 4**
   [Fig. 4] est une autre vue schématique en perspective d'un détail du tableau de la figure 1.
**Fig. 5**

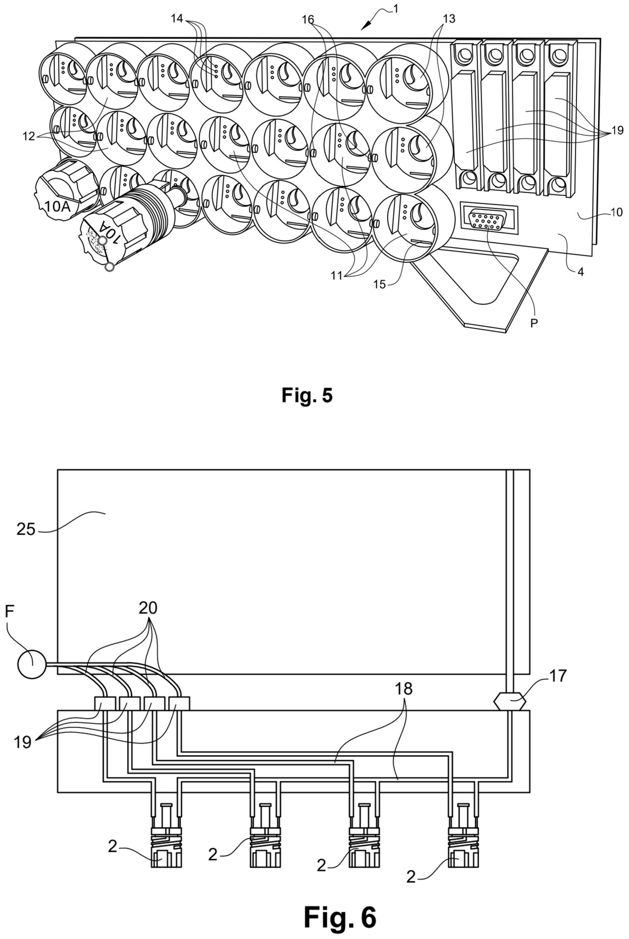

   [Fig. 5] est une vue en perspective arrière du tableau de la figure 1.
**Fig. 6**
   [Fig. 6] est une vue schématique de la distribution du courant électrique dans le tableau électrique de la figure 1.
**Fig. 7**

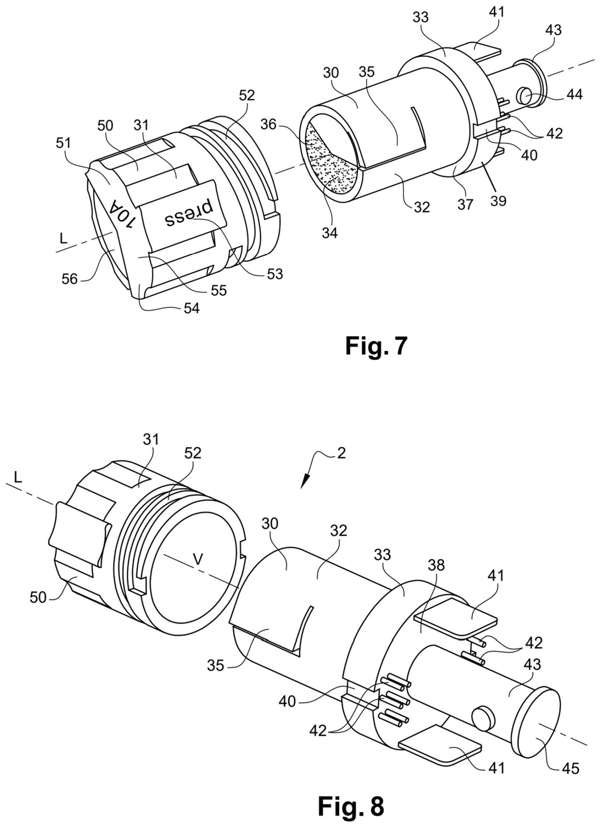

   [Fig. 7] est une vue schématique en perspective d'un disjoncteur, démonté, pour le tableau électrique des figures précédentes.
**Fig. 8**
   [Fig. 8] est une autre vue schématique en perspective du disjoncteur de la figure 7.
**Fig. 9**

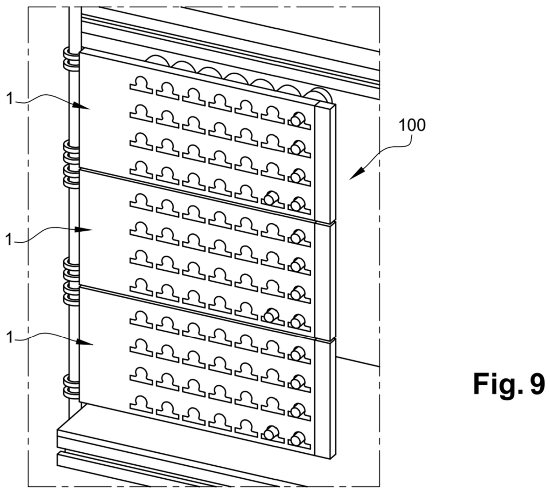

   [Fig. 9] est une vue schématique d'une armoire électrique munie d'une pluralité de tableaux électriques.

### Description des modes de réalisation

Les exemples et les conditions associées détaillés ici sont principalement destinés à aider le lecteur à comprendre les principes de la présente invention et non à limiter sa portée à ces exemples et conditions spécifiques. On comprendra que l'homme du métier peut concevoir divers agencements qui, bien qu'ils ne soient pas explicitement décrits ou représentés ici, incarnent néanmoins les principes de la présente invention et sont inclus dans son esprit et sa portée.

En outre, pour faciliter la compréhension, la description suivante peut décrire des mises en œuvre relativement simplifiées de la présente invention. Comme l'homme du métier le comprend, d'autres mises en œuvre de la présente invention peuvent être d'une plus grande complexité.

Dans certains cas, des exemples de modifications de la présente invention peuvent également être présentés. Ceci est fait simplement comme une aide à la compréhension, et, à nouveau pas pour définir la portée ou établir les limites de la présente invention. Ces modifications ne sont pas une liste exhaustive, et l'homme du métier pourra apporter d'autres modifications tout en restant dans le cadre de la présente invention.

En outre, toutes les déclarations ci-après relatives aux principes, aspects et mises en œuvre de la présente invention, ainsi que les exemples spécifiques de celle-ci, visent à englober à la fois les équivalents structurels et fonctionnels de celle-ci, qu'ils soient actuellement connus ou développés à l'avenir.

L'invention a pour objet un tableau électrique, référencé 1 sur les figures, pour un aéronef. Le tableau électrique 1 équipe une armoire électrique 100, autrement appelée baie avionique, telle qu'illustrée sur la figure 9. Sur la figure 9, on a représenté trois tableaux électriques 1.

Le tableau électrique 1 est destiné à recevoir des interrupteurs de circuit, ou disjoncteurs 2. Chacun des disjoncteurs 2 est dédié à un circuit électrique pour un équipement électrique de l'aéronef. Comme il sera détaillé ultérieurement, lorsque le disjoncteur 2 est verrouillé (ou engagé) dans le tableau électrique 1, un courant électrique circule dans le circuit électrique auquel il est dédié. Lorsque le disjoncteur 2 est déverrouillé du tableau électrique 1, l'alimentation électrique est coupée dans le circuit dédié.

Comme il ressort des figures 1 à 8, le tableau électrique 1 comprend un ensemble de plaques solidaires les unes des autres. Le tableau 1 comprend une première plaque, dite plaque avant 3, et une deuxième plaque, dite platine arrière 4, entre lesquelles sont disposées, depuis la plaque avant 3 vers la platine arrière 4, une plaque d'alimentation électrique 5, une plaque d'isolation électrique 6, et une plaque de circuit imprimé, ou plaque PCB (pour « printed circuit board » en anglais) 7.

Les plaques 3 à 7 sont superposées les unes aux autres et leurs contours des plaques internes 5, 6 et 7 sont de même dimensions ou de dimensions plus petites que celles des plaques externes que sont la plaque avant 3 et la platine arrière 4, de sorte que le tableau électrique 1 présente une forme générale de rectangle plat.

Comme particulièrement visible sur la figure 1, la plaque avant 3 présente une forme générale rectangulaire. La plaque avant 3 comprend des orifices 8, disposés, de façon non limitative, en trois rangées de sept orifices 8. Chacun des orifices 8 est dimensionné pour recevoir un disjoncteur 2 et une étiquette 9 associée à chaque orifice 8. Chaque étiquette 9 est un indicateur visuel de l'identité du disjoncteur 2, comme il sera détaillé ultérieurement.

Comme particulièrement visible sur les figures 3 et 5, la platine arrière 4 présente une forme générale rectangulaire. La platine arrière 4 comprend une plaque 10 surmontée d'un ensemble de logements 11, chaque logement 11 étant conformé pour recevoir un disjoncteur 2. Sur les figures, et de façon non limitative, les logements 11 sont organisés en trois rangées de sept.

Chaque logement 11 présente une forme de cylindre ouvert sur une ouverture circulaire 12 et qui repose sur la plaque. Pour chaque logement 11, la plaque elle-même est percée d'orifices 13 de diamètre inférieur à l'ouverture circulaire 12, chaque orifice 13 étant coaxial de l'ouverture associée 12. La plaque 10 comprend également des trous fins 14 (sur la figure 5, une rangée de trois pour chaque logement 11) et une fente rectiligne 15.

Chaque logement 11 comprend deux tétons 16, diamétralement opposés, pour bloquer le disjoncteur 2 dans le logement 11, comme il sera détaillé ultérieurement.

Comme particulièrement visible sur les figures 3, 4 et 6, la plaque d'alimentation électrique 5 comprend une entrée d'alimentation électrique 17, connectée à des tiges 18 conductrices d'électricité, ou barre omnibus (bus bar en anglais). La plaque 5 comprend également un ensemble de sorties 19 destinées à être reliées à des équipements de l'aéronef par des câbles 20 regroupés dans un faisceau F. Chaque tige 18 est munie d'ergots 18e faisant saillie vers la plaque d'isolation électrique 6.

On note que la plaque 5 est essentiellement remplie de vide et le terme plaque est utilisé du fait que le contour des tiges 12 est sensiblement rectangulaire.

Comme particulièrement visible sur la figure 3, la plaque d'isolation électrique 6 présente une forme générale rectangulaire. La plaque 6 comprend des orifices 20 de passage des disjoncteurs 2 et des étiquettes 9 et des fentes rectilignes 21.

Comme également visible sur la figure 3, la plaque PCB 7 présente une forme générale rectangulaire. La plaque 7 comprend un circuit imprimé, ainsi qu'une unité de traitement UT d'information, ou microprocesseur, connectée au circuit imprimé. Le microprocesseur est configuré pour contrôler une encre électronique, pour imprimer sur les étiquettes 9 des caractéristiques relatives aux disjoncteurs 2. La plaque PCB 7 comprend également des trous fins 22 et des orifices circulaires 23 et des fentes rectilignes 24.

On décrit maintenant la distribution du courant électrique dans le tableau 1, en référence à la figure 6.

Comme visible sur cette figure, en position de fonctionnement, un centre d'alimentation électrique 25 est relié électriquement à l'entrée d'alimentation électrique 17. Les tiges conductrices 18, connectées à l'entrée 17, assurent l'alimentation en série des disjoncteurs 2. Chacun des disjoncteurs 2 est relié par l'une des sorties 19 à un équipement de l'aéronef.

On décrit maintenant en détail un disjoncteur 2, destiné à être connecté dans le tableau électrique 1, en référence aux figures 7 et 8.

Comme visible sur ces figures, chaque disjoncteur 2 présente une forme générale cylindrique comportant un cylindre de connexion électrique 30 et un capot 31, d'axe longitudinal L.

Le cylindre de connexion électrique 30 comprend une paroi longitudinale 32 s'étendant entre une base 33 et un sommet 34. La paroi longitudinale 32 est munie de deux cliquets 35 diamétralement opposés. Le sommet 34 est muni d'un indicateur visuel 36. L'indicateur visuel 36 est un disque dont un secteur est d'une première couleur et un deuxième secteur est d'une deuxième couleur. Sur les figures, les couleurs sont le vert et le rouge, le vert (secteur de 120°) indiquant que le disjoncteur 2 est connecté et le rouge (secteur de 240°) indiquant que le disjoncteur 2 n'est pas connecté, comme il sera expliqué ultérieurement.

La base 33 comprend une partie en forme d'anneau 37, et un socle 38, disposés de part et d'autre d'une paroi longitudinale 39. La partie en forme d'anneau 37 est destinée à recevoir le capot 31. La partie longitudinale 39 est munie de deux rainures 40 diamétralement opposées. Chaque rainure 40, de préférence droite, est un guide de l'un des tétons 16 des logements 11 de la platine arrière 4.

Le cylindre de connexion électrique 30 comprend également deux plaquettes de contact 41, pour recevoir le courant électrique, faisant saillie hors du socle. Le cylindre de connexion électrique 30 comprend aussi des broches 42, par exemple deux ensembles de broches 42, dites de contact auxiliaire. Les broches 42 indiquent le statut du disjoncteur 2. Une résistance interne, non illustrée, est associée à un statut donné. Par exemple, et non limitativement, une résistance de 10 Ω est utilisée pour un calibre de 2 A, une résistance de 100 Ω pour un calibre de 5 A, une résistance de 200 Ω pour 10 A, une résistance de 300 Ω pour 16 A...

Comme également visible sur les figures 7 et 8, le cylindre de connexion électrique 30 comprend une tige 43, de préférence centrale, disposée le long de l'axe longitudinal L. La tige 43 comprend au moins un bouton 44. Le bouton 44 comprend de préférence une puce. Le bouton 44 permet d'indiquer le calibre et la présence du disjoncteur 2, et le fait que le disjoncteur 2 est connecté ou non dans le tableau électrique 1, comme il va être détaillé ultérieurement. L'extrémité libre 45 de la tige 43 porte une inscription de l'ampérage, c'est-à-dire du calibre, du disjoncteur 2 (par exemple 2A, 5A, 10A, 16A...).

Le capot 31 présente une forme de cylindre creux, comprenant une paroi longitudinale 50 et un sommet 51. Un volume interne V est délimité entre le sommet 51 et la paroi longitudinale 50. Le volume interne V est dimensionné pour recevoir le cylindre de connexion électrique 30. La paroi longitudinale 50 est munie d'un filetage 52 de verrouillage du disjoncteur 2 dans la platine arrière 4. La paroi longitudinale 50 est également munie de deux boutons 53 de verrouillage/déverrouillage d'un cliquet respectif 35 du cylindre de connexion électrique 30. Le sommet 51 présente une partie 54 en forme de secteur angulaire, sur laquelle repose une indication 55 de l'ampérage du disjoncteur 2 (par exemple 2A, 5A, 10A, 16A...). Le secteur angulaire est le même que celui de la couleur de désengagement (par exemple couleur rouge, illustrée par des points sur les figures). Le sommet 51 comprend également une ouverture 56, de la forme d'un secteur angulaire correspondant au secteur de la couleur d'engagement (par exemple couleur verte, illustrée par du blanc sur les figures).

Pour assembler le disjoncteur 2, on insère le cylindre de connexion électrique 30 dans le capot 31, jusqu'à ce que le capot 51 repose sur la partie en anneau 37 du cylindre de connexion électrique.

Dans la position assemblée, le sommet 51 du capot 31 laisse apparaître la section rouge du cylindre de connexion électrique 30. Deux entrées 57 du filetage 52 du capot 31 sont disposées dans le prolongement d'une rainure respective 40 du cylindre de connexion 30. Les cliquets 35 retiennent les boutons 53 et empêchent toute rotation du capot 31.

Pour installer le disjoncteur 2 dans le tableau électrique 1, il faut d'abord insérer le disjoncteur 2 par l'ouverture circulaire 12 de son logement respectif 11. On fait alors glisser les tétons 16 dans l'une des rainures 40, jusqu'à l'entrée 57 du filetage 52. Ensuite, on appuie sur les boutons 53, ce qui libère les cliquets 35 et permet de faire tourner le capot 31, les tétons 16 se déplaçant dans le filetage 52 jusqu'à la position de verrouillage du disjoncteur 2 dans le logement 11.

Dans la position verrouillée, les broches 42 sont disposées dans les trous fins 14 de la platine arrière 4, et les trous fins 22 de la plaque PCB, ce qui assure une communication entre le disjoncteur 2 et le microprocesseur. Chaque plaquette 41 passe à travers une fente rectiligne 15 de la platine arrière 15, une fente rectiligne 24 de la plaque PCB et une fente rectiligne 21 de la plaque d'isolation 6, et repose contre les ergots 18e de la plaque d'alimentation 5, ce qui permet l'alimentation du circuit électrique, comme déjà décrit. La tige centrale 53 passe à travers l'orifice 13 du logement 11, l'orifice 23 de la plaque PCB, l'orifice 20 de la plaque d'isolation électrique 6 et l'orifice 8 de la plaque avant 3. L'extrémité de la tige 43 est visible et montre l'inscription de l'ampérage du disjoncteur 2 (par exemple 2A, 5A, 10A, 16A...). Dans cette position, le secteur en vert est visible, ce qui indique visuellement à un opérateur que le disjoncteur 2 est connecté, verrouillé, dans le tableau électrique 1.

Le tableau électrique 1 comprend un moyen de détermination de l'identité du panneau. Par identité, on entend son positionnement dans l'armoire électrique 100. Par exemple, il s'agit du tableau électrique numéro N dans l'armoire électrique 100, qui elle-même est la numéro M dans l'agencement électrique général de l'aéronef. Dans ce cas, l'identité du tableau électrique est le N, M.

Le moyen de détermination est relié à une unité de contrôle (par exemple une carte mère qui gère tous les tableaux électriques 1, ou tout au moins certains d'entre eux), qui lui transmet l'identité du tableau 1. On parle de déclaration de position.

La déclaration de position provient soit de la connexion d'une prise avec un adressage spécifique (connexion interne), soit de la connexion d'un can-bus intelligent à un réseau, soit d'une mise à jour via internet ou un réseau spécifique soit une intelligence artificielle.

Selon une première variante, le moyen est une prise et, selon les câbles connectés à la prise, l'unité de contrôle lui indique l'identité du tableau 1.

Selon une deuxième variante, les câbles connectés sont les mêmes et la distinction se fait par utilisation de résistances distinctes (par exemple, une première position du tableau est de 10 ohms, une deuxième position est de 100 ohms, une troisième de 200 ohms ...).

Selon une troisième variante, un interrupteur relié à la prise assure la déclaration d'adresse.

Selon une quatrième variante, une vis permet un contact électrique pour la déclaration d'adresse.

L'identité du disjoncteur 2 est communiquée au microprocesseur via la lecture de la puce 44, comme visible sur la figure 8.

Une fois connue la position du tableau électrique, le microprocesseur sait identifier quel nom et calibre indiquer pour chaque étiquette, via l'encre électronique.

Par exemple, les étiquettes 9 peuvent contenir les messages suivants : ventilation 10A, lumière 20A, ...

Le microprocesseur est également configuré pour comparer l'identité du disjoncteur qui lui est communiquée par l'unité de contrôle via la prise P à l'identité du disjoncteur qui lui est communiquée par les broches 42 du disjoncteur 2. Si les identités ne coïncident pas, le microprocesseur le microprocesseur fait inscrire un message d'erreur sur l'étiquette 9.

Le microprocesseur est également configuré pour détecter si le disjoncteur 2 est complètement inséré, grâce au bouton 44 qui permet d'indiquer le calibre et la présence du disjoncteur 2, et le fait que le disjoncteur 2 est connecté ou non dans le tableau électrique 1.

Ainsi, un premier rôle est de vérifier qu'un bon ampérage est à sa place (5A sur une place 5A par exemple) et de mettre l'encre électronique avec l'adresse "postale" comme prévu (c'est-à-dire l'étiquetage prévu). Un deuxième rôle est de savoir avec la proximité si le disjoncteur 2 est enclenché (par exemple il alimente une lumière en suivant ou non ) "ON" ou "OFF".

Des modifications et des améliorations aux mises en œuvre décrites ci-dessus de la présente invention peuvent apparaître à l'homme du métier. En particulier, les modes de réalisation et variantes décrites sont combinables dans la mesure où ils ne sont pas incompatibles. La description ci-dessus est illustrative au travers d'exemples plutôt que limitative. La portée de la présente invention est donc limitée uniquement par la portée des revendications ci-dessous.

## Revendications

1. Tableau électrique pour un aéronef, comprenant une première plaque (3), dite plaque avant, une deuxième plaque (4), dite platine arrière, une troisième plaque (7) comprenant un circuit imprimé, dite plaque PCB, la plaque PCB (7) comprenant une unité de traitement d'informations (UT), une quatrième plaque (5) pour l'alimentation électrique d'au moins un disjoncteur (2), dite plaque d'alimentation électrique, la plaque PCB (7) et la plaque d'alimentation électrique (5) étant disposées entre la plaque avant (3) et la platine arrière (4), chacune desdites plaques (3, 4, 5, 7) étant munie d'au moins un orifice de passage dudit disjoncteur (2).

2. Tableau électrique selon la revendication 1, comprenant une plaque d'isolation électrique (6) entre la plaque d'alimentation électrique (5) et la plaque PCB (7).

3. Tableau électrique selon l'une des revendications précédentes, dans lequel la platine arrière comprend au moins un logement (11) d'installation dudit disjoncteur (2).

4. Tableau électrique selon l'une des revendications précédentes, dans lequel la plaque PCB (7) comprend une étiquette (9) contenant de l'encre électrique, l'unité de traitement d'informations étant configurée pour commander des indications visuelles à l'encre électrique de l'étiquette.

5. Tableau électrique selon l'une des revendications précédentes, comprenant un moyen de détermination de son propre positionnement relativement à un schéma électrique de l'aéronef, conformé pour communiquer avec l'unité de traitement d'informations.

6. Tableau électrique selon l'une des revendications précédentes, comprenant un moyen de verrouillage (16) du disjoncteur (2) dans le tableau électrique (1).

7. Disjoncteur (2) pour un tableau électrique selon l'une des revendications précédentes, comprenant un moyen (42) d'identification du disjoncteur (2).

8. Disjoncteur (2) selon la revendication précédente, comprenant un moyen de visualisation d'un état verrouillé du disjoncteur (2) dans le tableau électrique (1) et d'un état déverrouillé du disjoncteur (2).

9. Armoire électrique pour un aéronef, comprenant au moins un tableau électrique (1) selon l'une des revendications 1 à 6 et/ou au moins un disjoncteur selon l'une des revendications 7 ou 8.

10. Aéronef, comprenant une armoire électrique selon la revendication précédente.
